# EUROPÄISCHE PATENTSCHRIFT

(11) **EP 4 103 450 B1**
(45) Veröffentlichungstag und Bekanntmachung des Hinweises auf die Patenterteilung: **07.02.2024**
(21) Anmeldenummer: 22723596.7
(22) Anmeldetag: 19.04.2022
(51) Int. Cl.: B62D 1/04, B62D 1/06

(54) **ANORDNUNG AUS EINEM EINE ELEKTRODE AUFWEISENDEN LENKRAD UND EINER VOR ELEKTRODENSEITIG EINGEKOPPELTER ÜBERSPANNUNG BESSER GESCHÜTZTEN AUSWERTEINHEIT ZUR KAPAZITIVEN BERÜHRERKENNUNG SOWIE ZUGEHÖRIGES KRAFTFAHRZEUG**
ASSEMBLY COMPOSED OF A STEERING WHEEL HAVING AN ELECTRODE AND OF AN EVALUATION UNIT, THE EVALUATION UNIT BEING BETTER PROTECTED AGAINST SURGE VOLTAGE COUPLED IN FROM THE ELECTRODE AND BEING PROVIDED FOR CAPACITIVE TOUCH DETECTION, AND ASSOCIATED MOTOR VEHICLE
ENSEMBLE CONSTITUÉ D'UN VOLANT PRÉSENTANT UNE ÉLECTRODE ET D'UNE UNITÉ D'ÉVALUATION QUI EST MIEUX PROTÉGÉE CONTRE LES SURTENSIONS INJECTÉES CÔTÉ ÉLECTRODE ET QUI EST DESTINÉE À ASSURER UNE DÉTECTION TACTILE CAPACITIVE, ET VÉHICULE AUTOMOBILE ASSOCIÉ

(30) Priorität: 22.04.2021 DE 102021110300
(43) Veröffentlichungstag der Anmeldung: 21.12.2022
(73) Patentinhaber: PREH GmbH, 97616 Bad Neustadt a.d. Saale (DE)
(72) Erfinder: Schneider, Manfred, 97723 Oberthulba/OT Reith (DE); Schmitt, Mario, 97616 Salz (DE)
(74) Vertreter: Lohmanns, Bernard
(86) Internationale Anmeldenummer: PCT/EP2022/060269
(87) Internationale Veröffentlichungsnummer: WO 2022/223532

(56) Entgegenhaltungen:
- DE-A1-102014 113 715
- DE-A1-102019 124 293

## Beschreibung

Die Erfindung betrifft eine Anordnung aus einem eine Elektrode zur kapazitiven Berührerkennung aufweisenden Lenkrad und einer mit der Elektrode elektrisch leitend verbundenen Auswertelektronik zur Detektion einer Berührung des Lenkrades insbesondere des Lenkradkranzes. Lenkräder haben sich weg von einfachen Eingabevorrichtungen für die Vornahme von manuellen Lenkeingaben einer Lenkeinrichtung eines Kraftfahrzeugs hin zu multifunktionalen Eingabegeräten gegebenenfalls mit Überwachung der Lenkkontrolle entwickelt. Es dient somit neben der lenkenden Steuerung eines Kraftfahrzeugs auch der Vornahme von berührbasierten Eingaben bis hin zu Gesteneingaben zur Steuerung von sonstigen Komponenten des Kraftfahrzeugs. Darüber hinaus ist es vermehrt zur Überwachung der Lenkkontrolle des Kraftfahrzeugführers beispielsweise beim Fahren des Kraftfahrzeugs aber insbesondere beim Wechsel in einen autonomen Fahrzustand des Kraftfahrzeugs und zurück ausgebildet. Die Berührerkennung erfolgt regelmäßig durch Ausbildung einer Messkapazität zwischen einer Elektrode und einem ersten mit der Fahrzeugmasse verbundenen ersten Masseanschluss. Nachteilig bei der kapazitiven Berührerkennung ist, dass diese anfällig für Überspannungen ist, also Spannungen, insbesondere transiente Spannungen, deren Maximalspannung den Betrag des zur Berührerkennung verwendeten Messpotenzials um eine oder mehrere Größenordnungen übersteigt. Dies führt gegebenenfalls dazu, dass die Berühreingabe gestört ist oder gar die Auswertelektronik geschädigt wird. Es ist daher bekannt, die Auswertelektronik auf ihrer mit der Elektrode verbundenen Eingangsseite durch eine Schutzschaltung vor Überspannungen zu schützen, wobei die Schutzschaltung mindestens ein in einer elektrischen Verbindung zwischen der Eingangsseite bzw. Elektrode und der Kraftfahrzeugmasse vorgesehenes Überspannungsableitelement aufweist. Diese Schutzschaltung sorgt dafür, dass die mit der Elektrode elektrisch verbundene Eingangsseite ungewollt anliegende Überspannung zur Kraftfahrzeugmasse hin abgeleitet wird. Dabei ist vorgesehen, dass die Überspannung bei den üblichen Schutzschaltungen nahezu verlustfrei an den zugehörigen zweiten Masseanschluss gelangt, über den üblicherweise die Auswertelektronik "geerdet" ist. Da aber der erste Masseanschluss und der zweite Masseanschluss räumlich auseinanderfallen und durch ein als elektrischen Leiter zu betrachtenden metallischen Karosserie- und/oder Fahrgestellabschnitt voneinander getrennt sind, kommt es zu Potenzialverschiebungen zwischen dem ersten und zweiten Masseanschluss. Diese vorübergehenden Potenzialverschiebungen zwischen dem ersten und zweiten Masseanschluss können zu unvorhersehbaren Störungen bei der Berührauswertung bzw. Berührdetektion durch die Auswertelektronik führen, wie Fehldetektionen, was insbesondere bei einer Überwachung der Lenkkontrolle des Kraftfahrzeugführers oder beim Übergang von einem autonomen Fahrzustand zu einer Lenkkontrolle durch den Kraftfahrzeugführer oder umgekehrt nicht tolerierbar ist.

In diesem Zusammenhang offenbart das Dokument DE 10 2019 124 293 A1 die Merkmale des Oberbegriffs des unabhängigen Anspruchs und das Dokument DE 10 2014 113 715 A1 eine Schutzschaltung für den Schutz elektronischer Steuerungen in einem Kraftfahrzeug.

Vor diesem Hintergrund bestand Bedarf nach einer Lösung, bei der eine Anordnung aus einem eine Elektrode zur kapazitiven Berührerkennung aufweisenden Lenkrad und einer mit der Elektrode elektrisch leitend verbundenen Auswertelektronik zur Detektion einer Berührung des Lenkrades verbessert vor elektrodenseitig eingekoppelter Überspannung geschützt ist. Diese Aufgabe wird durch eine Anordnung gemäß Anspruch 1 gelöst. Ein gleichermaßen vorteilhaftes Kraftfahrzeug ist Gegenstand des nebengeordneten Anspruchs. Vorteilhafte Ausgestaltungen sind jeweils Gegenstand der abhängigen Ansprüche.

Die Erfindung betrifft eine Anordnung für ein Kraftfahrzeug aus einem eine Elektrode aufweisenden Lenkrad und einer vor einer elektrischen Überspannung zu schützenden Auswertelektronik. Der Begriff Kraftfahrzeug soll dabei auch eine softwaregestützte Simulation eines Kraftfahrzeugs beinhalten, bei der das Lenkrad eine Eingabevorrichtung zur Bewirkung einer virtuellen Lenkbewegung eines simulierten Kraftfahrzeugs ausbildet. Im Allgemeinen handelt es sich bei dem Lenkrad um eine Komponente einer Lenkung eines Kraftfahrzeugs, mit dem der Kraftfahrzeugführer durch Drehen eine Richtungsänderung des reellen oder virtuellen Kraftfahrzeugs bewirkt, indem beispielsweise ein oder mehrere Räder des Kraftfahrzeugs ihre Lenkstellung ändern.

Erfindungsgemäß ist die Auswerteinheit mit einer oder mehreren Elektroden zur kapazitiven Detektion einer Berührung des Lenkrads leitend verbunden. Das Lenkrad weist erfindungsgemäß einen Lenkradkranz und einen elektrisch leitfähigen Lenkradkern zur Festlegung an einer Kraftfahrzeugseitigen Lenkradwelle auf. Der Lenkradkern ist beispielsweise aus einem Metall oder einer metallischen Legierung und bildet eine Lenkradnabe zur lösbaren Befestigung an einer Lenkwelle des Kraftfahrzeugs aus. Beispielsweise ist eine Schraubverbindung zwischen der Lenkwelle und der Lenkradnabe vorgesehen. Beispielsweise wird die Schraubverbindung durch einen Pralltopf abgedeckt. Beispielsweise ist der Lenkradkranz ringförmig oder alternativ als ein oder mehrere Ringsegmente ausgebildet. Der Lenkradkern erstreckt sich beispielsweise von der Lenkradnabe über die Lenkradspeiche bis in den Lenkradkranz, so dass letzterer beispielsweise durch eine oder mehrere Lenkradspeichen an der Lenkradnabe festgelegt ist. Beispielsweise ist die Elektrode in den Lenkradkranz integriert.

Erfindungsgemäß ist der Lenkradkern über einen ersten ohmschen Verlustwiderstand mit einem ersten Masseanschluss elektrisch leitend verbunden.

Eine zur Anordnung erfindungsgemäß gehörige Auswertelektronik ist erfindungsgemäß ausgebildet, die Elektrode mit einem elektrischen Messpotenzial zur Berührdetektion zu beaufschlagen, um anhand einer Veränderung einer zwischen der Elektrode und dem Lenkradkern gebildeten Messkapazität die Berührung des Lenkradkranzes zu detektieren. Die Auswertelektronik ist erfindungsgemäß ferner mit einem zweiten Masseanschluss elektrisch leitend verbunden.

Hier meint "zweiter Anschluss", dass es sich nicht um denselben, nämlich ersten Anschluss handelt. Erfindungsgemäß sind erster und zweiter Masseanschluss räumlich getrennt voneinander und über eine Masseverbindung elektrisch leitend verbunden, so dass diese bevorzugt ein gemeinsames Massepotenzial definieren bzw. anstreben.

Erfindungsgemäß ist zwischen der Elektrode und dem Lenkradkern eine Verbindung vorgesehen, die ein Überspannungsableitelement aufweist, so dass die Verbindung bei elektrodenseitig anliegendem Messpotenzial hochohmig, also den Stromfluss zwischen der Elektrode und dem Lenkradkern hindernd oder bevorzugt sperrend wirkend, ist und bei elektrodenseitiger Überspannung niederohmig, also den Stromfluss zwischen beiden möglichst ungehindert durchlassend, ist, um im letzteren Fall die Überspannung von der Elektrode über den Lenkradkern zum ersten Masseanschluss abzuleiten. Beispielsweise unterscheidet sich der niederohmige und der hochohmige Zustand um mehr als eine, bevorzugt mehr als drei, Größenordnungen Ohm. Die Überspannung unterscheidet sich beispielsweise um mehr als eine, bevorzugt mehr als drei, Größenordnungen Volt von dem Messpotenzial.

Durch die erfindungsgemäße Lösung wir die Überspannung über den ersten ohmschen Verlustwiderstand zuerst zum ersten Masseanschluss geleitet, um über die Masseverbindung zur Auswerteinheit zu gelangen, wodurch die Überspannung mindestens um die am ersten ohmschen Verlustwiderstand abfallende Verlustspannung verringert wird, was dazu führt, dass eine durch die Überspannung bewirkte Potenzialverschiebung an dem zweiten Masseanschluss gar nicht oder allenfalls verringert auftritt, und die Auswertelektronik an ihrem Masseanschluss nicht oder zumindest verringert mit dem aus der Ableitung der Überspannung resultierendem Potenzial beaufschlagt wird. Die Detektion der Berührung durch die Auswertelektronik muss daher im Überspannungsfall nicht unterbrochen werden und wird nicht gestört. Die Funktion der kapazitiven Berührdetektion beruht beispielsweise auf der Änderung des elektrischen Feldes in der Umgebung vor der Elektrode (aktive Zone). Die Auswertelektronik weist beispielsweise eine RC-Oszillatorschaltung auf. Es wird während der Beaufschlagung mit dem Messpotenzial die Kapazität zwischen der Elektrode und dem elektrischen Massepotenzial gemessen. Statt eines Massepotenzials kann auch eine speziell vorgesehene Gegenelektrode mit einem zugehörigen Massepotenzial vorgesehen sein. Durch die Annäherung eines metallischen oder nicht metallischen Stoffes an die Elektrode, insbesondere bei Berührung des Lenkradkranzes, vergrößert sich die Kapazität und beeinflusst so die Schwingungsamplitude des RC-Oszillators. Diese Änderung bewirkt, dass eine nachgeschaltete Triggerstufe "kippt" und ihren Ausgangszustand ändert, wodurch eine Berührung positiv detektiert wird. Eine Massepotenzialverschiebung an der Auswertelektronik durch Überspannung hat folglich verheerende Auswirkung auf die Berührdetektion.

Das Überspannungsableitelement kann Teil einer mehrkomponentigen elektronischen Schaltung sein, die die elektrische Verbindung zwischen der Elektrode und dem Lenkradkern herstellt. Bevorzugt ist das zuvor erwähnte, in der elektrischen Verbindung zwischen der Elektrode und dem Lenkradkern vorgesehene Überspannungsableitelement eine Diode, wie eine Transient-Absorption-Zener-Diode oder eine Transient-Voltage-Suppresssor-Diode. Bevorzugt ist das Überspannungsableitelement räumlich näher der Auswertelektronik angeordnet als dem Lenkradkern.

Gemäß einer bevorzugten Ausführungsform ist der Lenkradkern ferner über einen Kondensator mit dem zweiten Masseanschluss verbunden. Dies hat den Vorteil, dass ein an dem Lenkradkern anliegendes Potenzial während des Beaufschlagens der Elektrode mit der Messkapazität bzw. bei Messkapazitätsänderungen stabilisiert wird und elektromagnetische Wechselwirkungen zwischen dem Lenkradkern und der Elektrode bei deren Funktion als Messelektrode, also außerhalb des Falls der Überspannungsableitung durch das Überspannungsableitelement, minimiert werden. Bevorzugt ist dem Kondensator ein zweiter ohmscher Verlustwiderstand, der größer als der erste ohmsche Verlustwiderstand ist, parallelgeschaltet, um so ein RC-Glied auszubilden. Der zweite ohmsche Verlustwiderstand ist größer gewählt, um im Überspannungs- und Ableitfall einen höheren Ableitstrom über den Lenkradkern und den ersten Masseanschluss sicherzustellen.

Bevorzugt liegt der erste ohmsche Verlustwiderstand im Bereich von 500 Ω bis 10 kΩ, bevorzugt im Bereich 800 Ω bis 1,2 k Ω.

Bevorzugt wird die Überspannung über die Lenkradwelle zum ersten Masseanschluss geleitet. Bevorzugt wird der erste ohmsche Verlustwiderstand im Wesentlichen durch einen Kontaktwiderstand im Bereich der Lagerung der Lenkradwelle ausgebildet wird. Der erste ohmsche Verlustwiderstand ist beispielsweise als ein über den gesamten Verstellweg des Lenkrads von einem Lenkanschlag zum entgegengesetzten Lenkanschlag gemittelter Widerstand zu bestimmen.

Erfindungsgemäß fallen der erste Masseanschluss und der zweite Masseanschluss räumlich nicht zusammen und sind bevorzugt einen räumlichen Mindestabstand von 0,5 m zueinander einhaltend angeordnet.

Bevorzugt sind der erste Masseanschluss und der zweite Masseanschluss über die Masseverbindung potenzialausgleichend, das heißt annähernd nullohmig und dabei ein gemeinsames Massepotenzial definierend oder bevorzugt niederohmig, d.h. einen maximal ein- oder zweistelligen, ohmschen Widerstand aufweisend, elektrisch leitend verbunden.

Gemäß einer Ausgestaltung wird wenigstens ein Masseanschluss aus erstem und zweitem Masseanschluss durch eine lösbare elektromechanische Verbindungseinrichtung, wie eine lösbare kraftschlüssige Verbindungseinrichtung, ausgebildet. Bevorzugt werden beide, erster und zweiter Masseanschluss, jeweils durch eine lösbare elektromechanische Verbindungseinrichtung, wie eine lösbare kraftschlüssige Verbindungseinrichtung, ausgebildet.

Bevorzugt ist die Elektrode durch einen Heizdraht einer Lenkradheizeinrichtung ausgebildet. Beispielsweise wird der Heizbetrieb durch Beaufschlagung des Heizdrahtes mit einem pulsweitenmodulierten Heizstrom durchgeführt, während die Berührdetektion jeweils in einer Totzeit dieser Beaufschlagung erfolgt.

Bevorzugt sind die Auswertelektronik und das Überspannungsableitelement außerhalb des Lenkrads angeordnet. Beispielsweise sind die Auswertelektronik und die Leseeinheit hinter einer Lenksäulenverkleidung oder einer Blende des Armaturenbretts oder der Mittelkonsole des Kraftfahrzeugs angeordnet.

Die Erfindung betrifft ferner ein Kraftfahrzeug mit der Anordnung in einer der zuvor beschriebenen Ausführungsformen. Dabei ist die elektrisch leitende Masseverbindung zwischen dem ersten Masseanschluss und dem zweiten Masseanschluss zumindest abschnittsweise durch eine Karosserie und/oder ein Fahrgestell des Kraftfahrzeugs ausgebildet.

Die Erfindung wird anhand der nachfolgenden Figuren näher erläutert. Die Figuren sind dabei nur beispielhaft zu verstehen und stellen jeweils lediglich eine bevorzugte Ausführungsvariante dar. Es zeigen:
- Fig. 1: eine schematische Darstellung einer ersten Ausführungsform der erfindungsgemäßen Anordnung;
- Fig. 2: eine schematische Darstellung einer zweiten Ausführungsform der erfindungsgemäßen Anordnung.

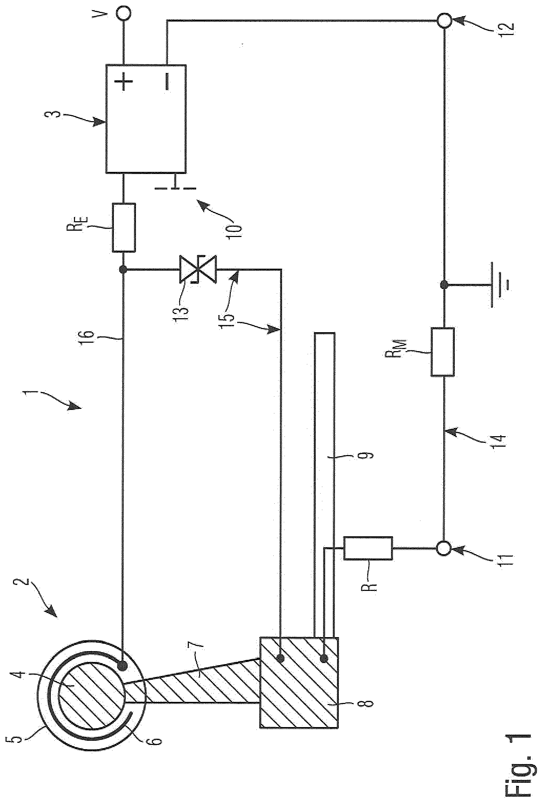

Figur 1 zeigt eine Ausführungsform der erfindungsgemäßen Anordnung 1. Die erfindungsgemäße Anordnung 1 umfasst ein Lenkrad 2 sowie eine außerhalb des Lenkrads 2 angeordnete Auswertelektronik 3. Die Auswertelektronik 3 wird durch ein Überspannungsableitelement 13, welches ebenfalls außerhalb des Lenkrads 2 angeordnet ist, vor eingangsseitiger Überspannung geschützt. Die Auswertelektronik 3 ist zur kapazitiven Detektion einer Berührung des Lenkrads 2 ausgebildet und somit ist der Messeingang der Auswertelektronik 3 über einen Eingangswiderstand R_{E} mit einer am oder im Lenkrad 2 angeordneten Elektrode 6 elektrisch leitend verbunden.

Das Lenkrad 2 ist in den Figuren nur ausschnittsweise und nicht detailgetreu dargestellt. Es weist einen leitfähigen, bevorzugt aus einem Metall oder metallischen Legierung hergestellten Lenkradkern 4 auf, der an einer Lenkradwelle 9 des nicht dargestellten Kraftfahrzeugs festgelegt ist. Der Lenkradkern 4 bildet eine Lenkradnabe 8 aus, die der Festlegung an der Lenkradwelle 9 dient und ist elektrisch leitend mit einem ersten Masseanschluss 11 verbunden. Der erste Masseanschluss 11 wird durch eine lösbare, kraftschlüssig wirkende, elektromechanische Verbindungseinrichtung zur Herstellung einer elektrischen Verbindung mit der Kraftfahrzeugkarosserie oder dem Kraftfahrzeugfahrgestell ausgebildet. Der Lenkradkern 4 erstreckt sich über wenigstens eine Lenkradspeiche 7 zu einem zum Lenkrad 2 gehörigen Lenkradkranz 5, in dem der Lenkradkern 4 ein inneres, den Lenkradkranz 5 stabilisierendes Skelett ausbildet, welches von einem Kunststoff-, Leder- oder Holzmantel umgeben ist. Der Lenkradkranz 5 ist beispielsweise ringförmig oder zumindest in Form eines Ringsegmentes ausgebildet und bildet die Grifffläche für einen Kraftfahrzeugführer aus, deren Berührung es gilt zu detektieren. In diesen Mantel des Lenkradkranzes 5 ist eine sich entlang des Umfangs des Lenkradkranzes 5 erstreckende Elektrode 6 vorgesehen, die abgesehen von der nachfolgend beschriebenen Verbindung 15 zur Überspannungsableitung elektrisch isoliert gegenüber dem Lenkradkern 4 ist. Es dürfte dem Fachmann klar sein, dass je nach gewünschtem Detektionsergebnis auch mehrere Elektroden, wie ein Elektrodenarray, vorgesehen sein können, um beispielsweise eine ortsaufgelöste Berührdetektion auf der Berührfläche des Lenkradkranzes 5 durchführen zu können.

Die Elektrode 6 ist bei dieser Ausführungsform durch einen Heizdraht einer nicht dargestellten Lenkradheizung ausgebildet, welche den Heizdraht mit einem pulsweitenmodulierten Heizstrom beaufschlagt, während in der Totzeit dieses Heizstroms die Elektrode 6 der Berührdetektion zur Verfügung steht. Die Elektrode 6 wird über eine elektrisch leitende Verbindung 16 durch die Auswertelektronik 3 mit einem Messpotenzial beaufschlagt. Die Auswertelektronik 3 ist neben der elektrischen Verbindung 16 zur Elektrode 6 ferner mit einer Versorgungsspannung V verbunden, sowie über ihren Massenausgang an einen zweiten Masseanschluss 12 angeschlossen, der durch eine lösbare, kraftschlüssig wirkende, elektromechanische Verbindungseinrichtung zur Herstellung einer elektrischen Verbindung mit der Kraftfahrzeugkarosserie oder dem Kraftfahrzeugfahrgestell ausgebildet ist.

Anhand einer Veränderung einer zwischen der Elektrode 6 und dem mit dem ersten Masseanschluss 11 leitend verbundenen Lenkradkern 4 gebildeten Messkapazität wird die Berührung des Lenkradkranzes 5 durch die Auswertelektronik 3 detektiert. Die Funktion der kapazitiven Berührdetektion beruht beispielsweise auf der Änderung des elektrischen Feldes in der Umgebung vor der Elektrode 6, genauer im Bereich der Oberfläche des Lenkradkranzes 5. Die Auswertelektronik 3 weist beispielsweise eine RC-Oszillatorschaltung auf. Es wird während der Beaufschlagung mit dem Messpotenzial die Kapazität zwischen der Elektrode 6 und der mit dem elektrischen Massepotenzial beaufschlagten Gegenelektrode, hier dem Lenkradkern 4, gemessen. Durch die Annäherung einer Hand des Fahrers an die Elektrode 6, insbesondere bei Berührung des Lenkradkranzes 5, vergrößert sich die Kapazität und beeinflusst so die Schwingungsamplitude des RC-Oszillators. Diese Änderung bewirkt, dass eine nachgeschaltete, zur Auswertelektronik 3 gehörige Triggerstufe "kippt" und ihren Ausgangszustand ändert, wodurch eine Berührung positiv detektiert wird, und das Detektionsergebnis über einen Digitalausgang 10 beispielsweise als Teil eines BUS-Systems, wie einem CAN-Bus ausgegeben wird. Die Empfindlichkeit der Auswertelektronik 3 kann im Allgemeinen durch Wahl des Schaltabstandes eingestellt werden. Eine Massepotenzialverschiebung an der Auswertelektronik durch Überspannung am zweiten Masseanschluss hat folglich verheerende Auswirkung auf die Berührdetektion.

Es ist zwischen der Elektrode 6 und dem Lenkradkern 4 eine Verbindung 15 vorgesehen, die ein Überspannungsableitelement 13 aufweist, so dass die Verbindung bei elektrodenseitig anliegendem Messpotenzial hochohmig, also einen Stromfluss hindernd oder bevorzugt sperrend wirkend ist und bei elektrodenseitiger Überspannung niederohmig, also den Stromfluss möglichst ungehindert durchlassend, ist, um im letzteren Fall die Überspannung zum Lenkradkern 4 zu leiten. Beispielsweise unterscheidet sich der niederohmige und der hochohmige Zustand um mehr als eine bevorzugt mehr als drei Größenordnungen Ohm. Die Überspannung unterscheidet sich beispielsweise um mehr als eine bevorzugt mehr als drei Größenordnungen Volt von dem Messpotenzial. Da der Lenkradkern 4 ferner über einen ersten ohmschen Verlustwiderstand R mit dem ersten Masseanschluss 11 elektrisch leitend verbunden ist, wird die Überanspannung am ersten Masseanschluss 11 abgeleitet und ist durch die am ersten Verlustwiderstand R abfallende Verlustspannung reduziert, bevor sie über die gemeinsame Masseleitung 14, die beispielsweise durch die nicht dargestellte Kraftfahrzeugkarosserie oder das nicht dargestellte Kraftfahrzeugfahrgestell ausgebildet ist, realisiert ist, den zweiten Masseanschluss 12 der Auswertelektronik 3 erreicht. Ein weiterer Verlustwiderstand R_{M} , der sich durch ein Abstand von mehr als 0,5 m zwischen dem ersten Masseanschluss 11 und dem zweiten Masseanschluss 12 ergibt und beispielsweise im Bereich von 0,01 bis 99,99 Ohm liegen kann, wirkt unterstützend. Der erste ohmsche Verlustwiderstand R liegt beispielsweise im Bereich von 500 Ω bis 10 kΩ, bevorzugt im Bereich 800 Ω bis 1,2 k Ω. Hier wird die Überspannung über die Lenkradwelle 9 zum ersten Masseanschluss 11 geleitet. Der erste ohmsche Verlustwiderstand R wird im Wesentlichen durch einen Kontaktwiderstand im Bereich der nicht dargestellten Lagerung der Lenkradwelle 9 ausgebildet. Der erste ohmsche Verlustwiderstand R ist beispielsweise als ein über den gesamten Verstellweg des Lenkrads 2 von einem Lenkanschlag zum entgegengesetzten Lenkanschlag gemittelter Widerstand zu bestimmen.

Durch die erfindungsgemäße Lösung wird die Überspannung über den ersten ohmschen Verlustwiderstand R zuerst zum ersten Masseanschluss 11 geleitet, um über die Masseverbindung 14 zur Auswerteinheit 3 zu gelangen, wird dabei mindestens um die am ersten ohmschen Verlustwiderstand R abfallende Verlustspannung verringert, was dazu führt, dass eine durch die Überspannung bewirkte Potenzialverschiebung an dem zweiten Anschluss 12 gar nicht oder allenfalls verringert auftritt, und die Auswertelektronik 3 an ihrem Masseausqanq nicht oder zumindest verringert mit dem aus der Ableitung der Überspannung resultierendem Potenzial beaufschlagt wird.

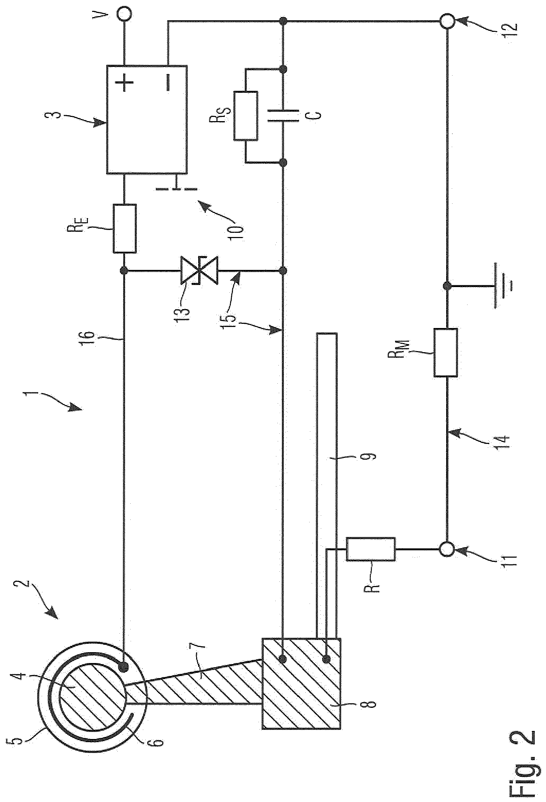

Figur 2 zeigt eine zweite Ausführungsform der erfindungsgemäßen Anordnung 1. Hier ist der Lenkradkern 4 ferner über einen Kondensator C mit dem zweiten Masseanschluss 12 verbunden. Dies hat den Vorteil, dass ein an dem Lenkradkern 4 anliegendes Potenzial während des Beaufschlagens der Elektrode 6 mit der Messkapazität bzw. bei Messkapazitätsänderungen stabilisiert wird und elektromagnetische Wechselwirkungen zwischen dem Lenkradkern 4 und der Elektrode 6 bei deren Funktion als Messelektrode, also außerhalb des Falls der Überspannungsableitung durch das Überspannungsableitelement, minimiert werden. Optional ist dem Kondensator C ein zweiter ohmscher Verlustwiderstand R_{S}, der größer als der erste ohmsche Verlustwiderstand R ist, parallelgeschaltet, um so ein RC-Glied auszubilden. Der zweite ohmsche Verlustwiderstand R_{S} ist größer gewählt, um im Überspannungs- und Ableitfall einen höheren Ableitstrom über den Lenkradkern 4 und den ersten Masseanschluss 11 sicherzustellen.

## Patentansprüche

1. Anordnung (1) für ein Kraftfahrzeug aus einem eine Elektrode (6) aufweisenden Lenkrad (2) und einer vor einer elektrischen Überspannung zu schützenden Auswertelektronik (3), die mit der Elektrode (6) zur kapazitiven Detektion einer Berührung des Lenkrads (2) elektrisch leitend verbunden ist, wobei das Lenkrad (2) einen Lenkradkranz (5) und einen elektrisch leitfähigen Lenkradkern (4) zur Festlegung an einer Lenkradwelle (9) aufweist, wobei der Lenkradkern (4) über einen ersten ohmschen Verlustwiderstand (R) mit einem ersten Masseanschluss (11) elektrisch leitend verbunden ist, wobei die Auswertelektronik (3) ausgebildet ist, die Elektrode (6) mit einem elektrischen Messpotenzial zur Berührdetektion zu beaufschlagen, um anhand einer Veränderung einer zwischen der Elektrode (6) und dem Lenkradkern (4) gebildeten Messkapazität die Berührung des Lenkradkranzes (12) zu detektieren;
**dadurch gekennzeichnet, dass** die Auswertelektronik (3) ferner mit einem zweiten Masseanschluss (12) elektrisch leitend verbunden ist, wobei der erste Masseanschluss (11) und der zweite Masseanschluss (12) räumlich getrennt voneinander angeordnet sind und über eine Masseverbindung (14) elektrisch leitend verbunden sind;
eine zwischen der Elektrode (6) und dem Lenkradkern (4) vorgesehene Verbindung (15), die ein Überspannungsableitelement (13) aufweist, so dass die Verbindung (15) bei elektrodenseitig anliegendem Messpotenzial hochohmig und bei elektrodenseitiger Überspannung niederohmig ist, um im letzteren Fall die Überspannung über den Lenkradkern (4) zum ersten Masseanschluss (11) abzuleiten.

2. Anordnung (1) gemäß Anspruch 1, wobei das Überspannungsableitelement (13) eine Diode, wie eine Transient-Absorption-Zener-Diode oder eine Transient-Voltage-Suppresssor-Diode, ist.

3. Anordnung (1) gemäß einem der vorhergehenden Ansprüche, wobei der Lenkradkern (4) ferner über einen Kondensator (C) mit dem zweiten Masseanschluss (12) verbunden ist.

4. Anordnung (1) gemäß dem vorhergehenden Anspruch, wobei dem Kondensator (C) ein zweiter ohmscher Verlustwiderstand (Rs), der größer als der erste ohmsche Verlustwiderstand (R) ist, parallelgeschaltet ist.

5. Anordnung (1) gemäß einem der vorhergehenden Ansprüche, wobei der erste ohmsche Verlustwiderstand (R) im Bereich von 500 Ω bis 10 kΩ liegt.

6. Anordnung (1) gemäß einem der vorhergehenden Ansprüche, wobei die Überspannung über die Lenkradwelle (9) zum ersten Masseanschluss (11) geleitet wird.

7. Anordnung (1) gemäß einem der vorhergehenden Ansprüche, wobei der erste ohmsche Verlustwiderstand (R) im Wesentlichen durch einen Kontaktwiderstand im Bereich der Lagerung der Lenkradwelle (9) ausgebildet wird.

8. Anordnung (1) gemäß einem der vorhergehenden Ansprüche, wobei der erste Masseanschluss (11) und der zweite Masseanschluss (12) einen räumlichen Mindestabstand von 0,5 m zueinander einhaltend angeordnet sind.

9. Anordnung (1) gemäß dem vorhergehenden Anspruch, wobei der erste Masseanschluss (11) und der zweite Masseanschluss (12) über die Masseverbindung (14) potenzialausgleichend und dabei ein gemeinsames Massepotenzial definierend oder bevorzugt niederohmig (R_{M}) elektrisch leitend verbunden sind.

10. Anordnung (1) gemäß einem der beiden vorhergehenden Ansprüche, wobei der erste Masseanschluss (11) und der zweite Masseanschluss (12) jeweils durch eine lösbare elektromechanische Verbindungseinrichtung ausgebildet sind.

11. Anordnung (1) gemäß einem der vorhergehenden Ansprüche, wobei die Elektrode (6) durch einen Heizdraht einer Lenkradheizeinrichtung ausgebildet ist.

12. Anordnung (1) gemäß einem der vorhergehenden Ansprüche, wobei die Auswertelektronik (3) und das Überspannungsableitelement (13) außerhalb des Lenkrads (2) angeordnet sind.

13. Kraftfahrzeug mit einer Anordnung (1) gemäß einem der vorhergehenden Ansprüche, wobei die leitende Masseverbindung zwischen dem ersten Masseanschluss und dem zweiten Masseanschluss zumindest abschnittsweise durch eine Karosserie und/oder ein Fahrgestell des Kraftfahrzeugs ausgebildet ist.

## Claims

1. Arrangement (1) for a motor vehicle comprising a steering wheel (2), having an electrode (6), and evaluation electronics (3), which are to be protected against an electrical overvoltage and which are electrically conductively connected to the electrode (6) for capacitive detection of a touch on the steering wheel (2), wherein the steering wheel (2) has a steering wheel rim (5) and an electrically conductive steering wheel core (4) for fixing to a steering wheel shaft (9), wherein the steering wheel core (4) is electrically conductively connected to a first ground connection (11) via a first ohmic resistor (R), wherein the evaluation electronics (3) are designed to apply an electrical measuring potential to the electrode (6) for touch detection in order to detect the touch on the steering wheel rim (12) on the basis of a change in a measuring capacitance formed between the electrode (6) and the steering wheel core (4); **characterized in that** the evaluation electronics (3) are furthermore electrically conductively connected to a second ground connection (12), wherein the first ground connection (11) and the second ground connection (12) are arranged spatially separate from one another and are electrically conductively connected via a ground path (14) ;
a connection (15), which is provided between the electrode (6) and the steering wheel core (4) and which has an overvoltage discharge element (13), so that the connection (15) is high-resistance when a measuring potential is applied on the electrode side and low-resistance in the event of an overvoltage on the electrode side, in order to discharge the overvoltage to the first ground connection (11) via the steering wheel core (4) in the latter case.

2. Arrangement (1) according to Claim 1, wherein the overvoltage discharge element (13) is a diode, such as a transient absorption Zener diode or a transient voltage suppressor diode.

3. Arrangement (1) according to one of the preceding claims, wherein the steering wheel core (4) is furthermore connected to the second ground connection (12) via a capacitor (C).

4. Arrangement (1) according to the preceding claim, wherein a second ohmic resistor (R_{S}), whereof the resistance is greater than the first ohmic resistance (R), is connected in parallel with the capacitor (C).

5. Arrangement (1) according to one of the preceding claims, wherein the first ohmic resistance (R) is in the range of 500 Ω to 10 kΩ.

6. Arrangement (1) according to one of the preceding claims, wherein the overvoltage is conducted to the first ground connection (11) via the steering wheel shaft (9).

7. Arrangement (1) according to one of the preceding claims, wherein the first ohmic resistance (R) is formed substantially by a contact resistance in the region of the bearing of the steering wheel shaft (9).

8. Arrangement (1) according to one of the preceding claims, wherein the first ground connection (11) and the second ground connection (12) are arranged such that they observe a minimum spatial distance of 0.5 m from one another.

9. Arrangement (1) according to the preceding claim, wherein the first ground connection (11) and the second ground connection (12) are electrically conductively connected with potential equalization, and thereby defining a common ground potential, or with preferably low resistance (R_{M}), via the ground path (14).

10. Arrangement (1) according to one of the two preceding claims, wherein the first ground connection (11) and the second ground connection (12) are each formed by a disconnectable electromechanical connecting device.

11. Arrangement (1) according to one of the preceding claims, wherein the electrode (6) is formed by a heating wire of a steering wheel heating device.

12. Arrangement (1) according to one of the preceding claims, wherein the evaluation electronics (3) and the overvoltage discharge element (13) are arranged outside the steering wheel (2).

13. Motor vehicle having an arrangement (1) according to one of the preceding claims, wherein the conductive ground path between the first ground connection and the second ground connection is formed at least partially by a body shell and/or a frame of the motor vehicle.

## Revendications

1. Ensemble (1) destiné à un véhicule automobile, qui est constitué d'un volant (2) présentant une électrode (6) et un système électronique d'évaluation (3) à protéger contre une surtension électrique, laquelle est reliée de manière électriquement conductrice à l'électrode (6) pour détecter de manière capacitive un contact avec le volant (2), le volant (2) possédant une jante de volant (5) et un moyeu de volant (4) électriquement conducteur pour assurer une fixation à un arbre de volant (9), le moyeu de volant (4) étant relié de manière électriquement conductrice à une première borne de masse (11) par l'intermédiaire d'une première résistance de perte ohmique (R), le système électronique d'évaluation (3) étant conçu pour appliquer à l'électrode (6) un potentiel de mesure électrique pour la détection de contact, afin de détecter un contact avec la jante de volant (12) sur la base d'une modification d'une capacité de mesure formée entre l'électrode (6) et le moyeu de volant (4) ;
**caractérisé en ce que**
le système électronique d'évaluation (3) est en outre relié de manière électriquement conductrice à une deuxième borne de masse (12), la première borne de masse (11) et la deuxième borne de masse (12) étant séparées spatialement l'une de l'autre et reliées de manière électriquement conductrice par une connexion de mise à la masse (14) ;
une connexion (15) prévue entre l'électrode (6) et le moyeu de volant (4), qui présente un élément de dérivation des surtensions (13), de sorte que la connexion (15) est à haute impédance lorsque le potentiel de mesure est appliqué côté électrode et à basse impédance en cas de surtension côté électrode, afin de dériver dans ce dernier cas la surtension vers la première borne de masse (11) par l'intermédiaire du moyeu de volant (4) .

2. Ensemble (1) selon la revendication 1, dans lequel l'élément de dérivation des surtensions (13) est une diode, telle qu'une diode Zener d'absorption des transitoires ou une diode de suppression des transitoires de tension.

3. Ensemble (1) selon l'une des revendications précédentes, dans lequel le moyeu de volant (4) est en outre relié à la deuxième borne de masse (12) par l'intermédiaire d'un condensateur (C).

4. Ensemble (1) selon la revendication précédente, dans lequel une deuxième résistance de perte ohmique (R_{S}), qui est supérieure à la première résistance de perte ohmique (R), est connectée en parallèle au condensateur (C).

5. Ensemble (1) selon l'une des revendications précédentes, dans lequel la première résistance ohmique de perte (R) est comprise entre 500 W et 10 k W.

6. Ensemble (1) selon l'une des revendications précédentes, dans lequel la surtension est envoyée vers la première borne de masse (11) par l'intermédiaire de l'arbre de volant (9).

7. Ensemble (1) selon l'une des revendications précédentes, dans lequel la première résistance ohmique de perte (R) est essentiellement formée par une résistance de contact dans la zone du palier de l'arbre de volant (9).

8. Ensemble (1) selon l'une des revendications précédentes, dans lequel la première borne de masse (11) et la deuxième borne de masse (12) sont disposées de manière à respecter une distance spatiale minimale de 0,5 m l'une par rapport à l'autre.

9. Ensemble (1) selon la revendication précédente, dans lequel la première borne de masse (11) et la deuxième borne de masse (12) sont reliées de manière électriquement conductrice par l'intermédiaire de la connexion de mise à la masse (14) en équilibrant les potentiels et en définissant ainsi un potentiel de masse commun ou de préférence à basse impédance (R_{M}).

10. Ensemble (1) selon l'une des deux revendications précédentes, dans lequel la première borne de masse (11) et la deuxième borne de masse (12) sont respectivement formées par un dispositif de connexion électromécanique amovible.

11. Ensemble (1) selon l'une des revendications précédentes, dans lequel l'électrode (6) est formée par un fil chauffant d'un dispositif de chauffage du volant.

12. Ensemble (1) selon l'une des revendications précédentes, dans lequel le système électronique d'évaluation (3) et l'élément de dérivation des surtensions (13) sont disposés à l'extérieur du volant (2) .

13. Véhicule automobile comportant un ensemble (1) selon l'une des revendications précédentes, dans lequel la connexion de mise à la masse conductrice entre la première borne de masse et la deuxième borne de masse est formée au moins par sections par une carrosserie et/ou un châssis du véhicule automobile.
